Europäisches Patentamt

European Patent Office

Office européen des brevets

(11) Numéro de publication : **0 531 214 B1**

(19)

(12) # FASCICULE DE BREVET EUROPEEN

(45) Date de publication du fascicule du brevet :
**09.08.95 Bulletin 95/32**

(51) Int. Cl.$^6$ : **H01S 3/025,** H01S 3/19,
G02F 1/015

(21) Numéro de dépôt : **92402408.6**

(22) Date de dépôt : **03.09.92**

(54) **Composant intégré laser-modulateur à super-réseau très couplé.**

(30) Priorité : **06.09.91 FR 9111046**

(43) Date de publication de la demande :
**10.03.93 Bulletin 93/10**

(45) Mention de la délivrance du brevet :
**09.08.95 Bulletin 95/32**

(84) Etats contractants désignés :
**DE GB IT NL**

(56) Documents cités :
**EP-A- 0 187 662
EP-A- 0 436 413
FR-A- 2 607 628
US-A- 4 905 253
PATENT ABSTRACTS OF JAPAN vol. 9, no. 19
(E-292) 25 janvier 1985 ; & JP-A-59 165 480
APPLIED PHYSICS LETTERS, vol. 48, no. 1, 6
Janvier 1986, New York, US, pp. 1-3; S. TARU-
CHA et al. :** "Monolithic integration of a laser
diode and an optical waveguide modulator
having a GaAs/A1GaAs quantum well double
heterostructure" **
Semiconductors and Semimetals, vol. 24,
Volume Editor Raymond Dingle, 1987, Academic Press, San Diego, USA, Chapter 1, C.
Weisbuch, pp. 23-29**

(73) Titulaire : **FRANCE TELECOM
Etablissement autonome de droit public,
6, Place d'Alleray
F-75015 Paris (FR)**
Titulaire : **CENTRE NATIONAL DE LA
RECHERCHE SCIENTIFIQUE
15, quai Anatole France
F-75007 Paris (FR)**

(72) Inventeur : **Allovon, Michel
49 av. Jean Moulin
F-92260 Fontenay aux Roses (FR)**
Inventeur : **Bigan, Erwan
11 rue Barrault
F-75013 Paris (FR)**
Inventeur : **Harmand, Jean-Christophe
21 rue Sacco et Vanzetti
F-94800 Villejuif (FR)**
Inventeur : **Voisin, Paul
13 rue de l'Epée de Bois
F-75005 Paris (FR)**

(74) Mandataire : **Signore, Robert et al
c/o BREVATOME
25, rue de Ponthieu
F-75008 Paris (FR)**

## Description

### Domaine technique

La présente invention a pour objet un composant intégré laser-modulateur à super-réseau très couplé. Elle trouve notamment des applications dans le domaine des télécommunications optiques, par exemple pour les liaisons numériques à haut débit et à longue distance, ainsi que dans le domaine de la commutation électro-optique.

L'invention utilise la technique de modulation d'intensité d'un faisceau lumineux par électro-absorption. Ce phénomène consiste en la variation d'absorption optique d'un matériau sous l'effet d'un champ électrique. Ce dernier est appliqué par exemple au moyen d'une diode PIN polarisée en inverse dans laquelle la région intrinsèque I (non intentionnellement dopée) contient le matériau électro-absorbant. Conformément à un mode de réalisation dit à "ondes guidées", la lumière est injectée dans la région intrinsèque I, parallèlement au plan des couches P, I et N.

La présente invention utilise également la technique de l'intégration d'un laser et d'un modulateur électro-optique sur un même substrat.

### Etat de la technique antérieure

L'intégration monolithique d'un laser à semiconducteur et d'un modulateur électro-optique en ondes guidées est un sujet très étudié aujourd'hui, surtout pour les longueurs d'ondes voisines de 1,55 µm. C'est en effet un composant stratégique pour les télécommunications à haut débit (plusieurs Gbit/s) et à longueur distance, car il conjugue la simplicité de montage du laser à modulation directe et les avantages de la modulation externe : grande bande passante et surtout faible fluctuation en longueur d'onde ("chirp"). Par ailleurs, l'intégration de ces deux éléments (laser-modulateur) permet de réduire considérablement les pertes optiques entre le laser et le modulateur, comparativement aux montages hybrides où le modulateur est rapporté à l'extérieur du laser.

Pour tirer pleinement parti de ce bon couplage optique, il est préférable d'utiliser un laser du type DFB (pour "Distributed FeedBack") ou un équivalent, qui permet d'éviter un miroir entre le laser et le modulateur. Par ailleurs, cette disposition est nécessaire pour le type d'application visé qui nécessite un fonctionnement monomode longitudinal.

Ces deux éléments d'un composant (laser-modulateur) utilisent des structures épitaxiées semblables du type double hétérostructure (en abrégé "DH") de type PIN, que l'on polarise en direct dans le cas du laser et en inverse dans le cas du modulateur. Cependant, il n'est généralement pas possible d'utiliser exactement la même couche active dans les deux éléments pour des raisons de compatibilité en longueur d'onde. En effet, les modulateurs électro-optiques utilisés jusqu'à présent, à effet FRANZ-KELDYSH (cf l'article de Y. NODA, M. SUZUKI, Y. KUSHIRO et S. AKIBA, publié dans IEEE J. Lightwave Technol., vol. LT-4, pp. 1445-1453, 1986) ou à effet STARK confiné quantiquement (cf l'article de K. WAKITA, I. KOTAKA, O. MITOMI, H. ASAI, Y. KAWAMURA et M. NAGANUMA, publié dans IEEE, J. Lightwave Technol., vol. LT-8, pp. 1027-1032, 1990) ne peuvent fonctionner que pour des longueurs d'ondes supérieures à celle du bord de la bande d'absorption de la couche active, puisque l'application d'un champ électrique dans le matériau électro-absorbant produit un décalage vers les grandes longueurs d'onde du front d'absorption. Cela signifie que l'application d'un champ électrique ne peut qu'augmenter l'absorption d'un matériau initialement transparent (en utilisant ces effets), et donc, qu'à la longueur d'onde de fonctionnement choisie, le matériau de la couche active doit être suffisamment transparent en l'absence de champ électrique (état passant du modulateur).

En revanche, dans le cas du laser, l'émission stimulée se produit à une énergie légèrement supérieure à celle de la bande interdite (ou "gap") de la couche active, en raison du remplissage des bandes jusqu'à obtention d'une densité de porteurs suffisante pour que l'inversion de population se produise. La longueur d'onde laser est donc légèrement inférieure à celle de la bande interdite de la couche active en l'absence de champ électrique (puisqu'un laser fonctionne en polarisation directe, donc sans champ appliqué à la couche active).

En toute rigueur, il faudrait tenir compte, dans le fonctionnement du laser, d'un autre effet qui peut permettre dans certains cas de rétablir la compatibilité en longueur d'onde entre le laser et le modulateur. Il s'agit de l'effet dit de "renormalisation du gap", qui entraîne une diminution de la bande interdite effective de la couche active d'un laser sous polarisation directe, diminution liée à l'augmentation de la densité de porteurs. Cet effet vient donc contrarier l'effet de remplissage des bandes, qui est également proportionnel à la densité de porteurs injectés, mais qui a tendance à diminuer la longueur d'onde de l'émission laser, alors que la "renormalisation du gap" a tendance à l'augmenter.

Dans la plupart des cas, et en particulier pour les matériaux susceptibles de fonctionner à 1,55 µm, l'effet

2

de renormalisation n'est pas suffisant pour annuler l'effet de remplissage des bandes. Cependant, la compatibilité en longueur d'onde entre un laser et un modulateur à effet STARK a été démontrée dans le cas de structures à puits quantiques en GaAs/GaAlAs fonctionnant à 0,8 μm, et cet effet a été invoqué pour expliquer ce comportement inhabituel. Un tel composant a été décrit par S. TARUCHA et H. OKAMOTO dans Appl. Phys. Lett., vol. 48, pp. 1-3, 1986.

Mis à part ce cas exceptionnel, lorsqu'il s'agit de réaliser un composant fonctionnant à grande longueur d'onde (vers 1,5 μm) sur un substrat en InP on utilise des couches actives différentes et donc de largeurs de bandes interdites différentes pour le laser et le modulateur.

On peut répartir les solutions connues en deux catégories selon qu'on utilise des structures épitaxiées différentes ou des structures similaires mais avec des variations localisées de la bande interdite :

## a) Structures épitaxiées différentes pour le laser et le modulateur

Cette catégorie se subdivise à son tour en deux sous-catégories selon que deux étapes d'épitaxie ou une seule sont mises en oeuvre :

### i) En deux étapes d'épitaxie

Ces techniques ont permis l'intégration de lasers DFB (à réseau distribué de BRAGG) avec des modulateurs classiques à effet FRANZ-KELDYSH à la longueur d'onde recherchée de 1,55 μm. Un tel composant est décrit par exemple par M. SUZUKI, Y. NODA, H. TANAKA, S. AKIBA, Y. KUSHIRO et H. ISSHIKI, dans IEEE J. Lightwave Technol., vol. LT-5, pp. 1277-1285, 1987 et par H. SODA, M. FURUTSU, K. SATO, N. OKAZAKI, S. YAMAZAKI, H. NISHIMOTO et H. ISHIKAWA, dans Electron. Lett., vol. 26, pp. 9-10, 1990.

La caractéristique de cette technique est l'utilisation de deux étapes d'épitaxie successives pour les couches actives du laser et du modulateur, ce qui permet d'optimiser séparément les matériaux actifs des deux éléments. Par exemple, pour un fonctionnement à 1,55 μm, si l'on utilise des structures classiques (c'est-à-dire non quantiques) pour le laser et pour le modulateur, on utilise un matériau semiconducteur quaternaire ayant une bande interdite située à 1,55 μm pour la couche active du laser, et un quaternaire de bande interdite de 1,45 μm pour la couche active d'un modulateur à effet FRANZ-KELDYSH.

### ii) En une seule étape d'épitaxie sur substrat gravé

Cette technique consiste à superposer les structures du laser et du modulateur en une seule étape d'épitaxie sur un substrat comportant des sillons gravés au préalable. La profondeur des sillons et l'épaisseur des couches sont calculées pour que les couches actives des deux composants se retrouvent à la même hauteur. Cela permet aussi d'optimiser séparément les couches actives des deux composants tout en réalisant un couplage en bout en une seule étape d'épitaxie. L'intégration d'un laser et d'un guide selon cette technique est décrite par D. REMIENS, B. ROSE, M. CARRE et V. HORNUNG dans J. Appl. Phys., vol. 68, pp. 2450-2453.

## b) Variation localisée de la bande interdite des couches actives

Dans le cas d'une couche active à puits quantiques, l'écart entre les longueurs d'onde de fonctionnement en laser et en modulateur est plus faible. En effet, la longueur d'onde du modulateur peut être plus proche de la longueur d'onde du front d'absorption, car ce front d'absorption est plus raide. D'autre part, la bande interdite de la couche active dépend non seulement de la composition des matériaux employés mais aussi de l'épaisseur des puits quantiques utilisés. Deux solutions sont alors envisageables :

### i) Variation localisée de composition ou d'épaisseur pendant l'épitaxie

Il a été montré, par exemple, que la vitesse de croissance dans des sillons gravés dans un substrat est plus grande que sur un substrat plan. Cet effet a été utilisé pour intégrer des lasers (épitaxiés sur une zone du substrat préalablement gravée) avec des guides (épitaxiés simultanément sur une zone plane adjacente) dans le système GaAs/GaAlAs (voir l'article de C.J. CHANG-HASNAIN, E. KAPON, J.P. HARBISON et L.T. FLOREZ, publié dans Appl. Phys. Lett., vol. 56, pp. 429-431, 1990). Des effets analogues sur la vitesse de croissance ont été démontrés pour d'autres systèmes de matériaux, en particulier à grande longueur d'onde (voir l'article de F.S. TURCO, M.C. TAMARGO, D.M. HWANG, R.E. NAHORY, J. WERNER, K. KASH et E. KAPON, publié dans Appl. Phys. Lett., vol. 56, pp. 72-74, 1990 et l'article de P. DEMEESTER, L. BUYDENS et P. VAN DAELE, publié dans Appl. Phys. Lett., vol. 57, pp. 168-170, 1990). Ces effets pourraient être utilisés pour une intégration laser-modulateur.

**ii) Variation localisée de la bande interdite après l'épitaxie**

Il est également possible de partir d'une épitaxie homogène et de modifier localement la bande interdite de la couche active de l'un des deux éléments et ceci de deux manières :
- par interdiffusion partielle des puits et des barrières. Dans ce cas, on augmente légèrement la bande interdite de la couche active du modulateur (décalage vers le bleu de la longueur d'onde) en provoquant une certaine interdiffusion des constituants des puits et des barrières. Ce décalage doit être localisé à la région du modulateur. Il peut être obtenu, par exemple, par implantation d'impuretés suivie d'un recuit ou par diffusion d'impuretés à haute température. Il a été montré dans GaAs/GaAlAs qu'un mélange partiel des puits quantiques permet des décalages en longueur d'onde suffisants pour une intégration (voir l'article de R.L. THORNTON, W.J. MOSBY et T.L. PAOLI, publié dans IEEE J. Lightwave Technol., vol. LT-6, pp. 786-792, 1988), tout en conservant l'existence de l'effet STARK confiné quantiquement dans la partie mélangée (voir l'article de H. RIBOT, F. LARUELLE et L.A. COLDREN, publié dans Appl. Phys. Lett., vol. 55, pp. 2526-2528, 1989).
- par dopage de la couche active du laser. Il est aussi possible de modifier la bande interdite du laser dans l'autre sens (décalage vers les grandes longueurs d'ondes), par exemple avec un dopage localisé de la couche active du laser par diffusion de zinc.

Toutes ces techniques connues ont l'inconvénient de dépendre, soit du processus d'épitaxie, soit de la famille de matériaux utilisée. De plus, elles comprennent toutes une ou plusieurs étapes critiques, dont la maîtrise est délicate et qui nuisent aux performances de l'un ou l'autre des éléments du composant.

On peut reprendre l'une après l'autre les solutions décrites précédemment pour en souligner les divers inconvénients :

**a) Structures épitaxiées différentes pour le laser et le modulateur**

Ces techniques présentent l'inconvénient d'être très lourdes, et délicates au niveau de l'épitaxie : reprise d'épitaxie ou épitaxie sur substrat gravé, ainsi qu'au niveau du processus technologique : structures épitaxiées non planes. Il est donc difficile d'obtenir une aussi bonne qualité de matériaux qu'avec des éléments séparés. Par ailleurs, il est difficile d'obtenir un bon couplage optique entre les deux couches actives, ce qui limite les performances du composant monolithique obtenu.

**b) Variation localisée de la bande interdite des couches actives**

**i) Variation localisée de composition ou d'épaisseur pendant l'épitaxie**

Ces techniques sont très délicates au niveau de l'épitaxie, difficiles à contrôler quant au résultat, avec des problèmes de qualité du matériau dans les zones où la vitesse de croissance est volontairement perturbée. Par exemple, les variations de vitesse de croissance obtenues sur substrat gravé ne respectent pas l'accord de maille dans le cas de composés ternaires ou quaternaires épitaxiés sur InP.

**ii) Variation localisée de la bande interdite après épitaxie**

Cette technique suppose une étape supplémentaire, qui n'est pas forcément facile à contrôler, en particulier pour l'obtention d'une valeur précise et reproductible du décalage en longueur d'onde visé.

Par ailleurs, la procédure de mélange elle-même peut dégrader la qualité du matériau (défauts d'implantation par exemple), ou introduire un dopage indésirable (diffusion d'impuretés dopantes). Enfin, l'interdiffusion des puits quantiques et des barrières affaiblit l'effet STARK confiné quantiquement et se traduit par une diminution des performances du modulateur.

**Exposé de l'invention**

La présente invention a justement pour but de remédier à ces inconvénients. A cette fin, elle propose d'utiliser ainsi que défini dans les revendications 1 et 2 comme couche active du laser et comme couche électro-absorbante du modulateur une même structure épitaxiée. Cette structure est un super-réseau de composition très couplé. Par super-réseau de composition, on entend une structure obtenue par des couches de composition différentes par opposition à des réseaux de couches de même composition mais de dopages alternés.

On sait qu'un super-réseau très couplé est une structure quantique d'un type particulier. On rappelle, à cet égard, qu'un super-réseau ("super-lattice" en terminologie anglosaxonne, ou SL en abrégé) très couplé et une succession de puits et de barrières de potentiel, dans laquelle les épaisseurs respectives des puits et des barrières sont très faibles, de sorte que les puits sont très couplés les uns avec les autres, par effet tunnel résonnant.

On distingue cette structure de celle dite à multipuits quantiques ("Multiple Quantum Well" en terminologie anglosaxonne ou MQW en abrégé) qui est une succession de puits et de barrières de potentiel, dans laquelle l'épaisseur des barrières est suffisamment grande pour que les puits ne soient pas couplés les uns avec les autres.

Un super-réseau très couplé peut fonctionner en modulateur de deux manières différentes, dans deux plages de longueur d'ondes distinctes :

- soit en modulateur à décalage vers le bleu (ou "blue-shift") comme décrit notamment dans le document FR-A-2 607 628,
- soit en modulateur à "transition oblique" comme décrit notamment dans le document FR-A-2 655 433.

Ces deux modes de fonctionnement sont possibles avec le composant de l'invention.

Il leur correspond deux types d'intégration : soit l'intégration d'un modulateur de type "décalage vers le bleu", qui est d'emblée compatible en longueur d'onde avec l'émission laser du même super-réseau couplé, soit l'intégration d'un modulateur à transition oblique, dont la plage de longueur d'onde est proche de la plage de longueur d'onde du fonctionnement laser, et pour lequel différents moyens simples peuvent être mis en oeuvre pour tenter d'obtenir une bonne compatibilité en longueur d'onde, essentiellement en décalant la longueur d'onde de fonctionnement du laser.

On observera que le super-réseau de l'invention est un super-réseau de composition (c'est-à-dire que la composition des couches alterne) et non un réseau de dopage où la composition des couches est toujours la même mais où le dopage alterne d'une couche à l'autre. Une structure à réseau de dopage est décrite, par exemple, dans la demande de brevet japonais n° 59-165480 (Patent Abstracts of Japan, vol. 9, n° 19 (E-292) 25 janvier 1985).Dans ce document, les couches ont toutes la même composition à savoir $In_{0,53}Ga_{0,47}As$, et sont fortement dopées, alternativement P et N.

Dans une telle structure à dopages alternés, on ne peut pas parler de "puits" ou de "barrières" ayant des bandes interdites différentes comme dans un super-réseau de composition. Ce type de structures est connu sous le nom de NIPI (n-i-p-i) car il nécessite, en pratique, des couches intrinsèques (non-dopées) (c'est le I de l'abréviation NIPI). De telles structures peuvent donner lieu à de l'électroabsorption mais les phénomènes mis en jeu n'ont rien à voir avec la localisation de WANNIER-STARK utilisée dans la présente invention.

**Brève description des dessins**

- la figure 1 représente la structure de bande d'un super-réseau très couplé (A) selon l'invention et, par comparaison, celle d'un puits quantique isolé (B),
- la figure 2 représente la structure de bande d'un super-réseau très couplé en présence d'un faible champ électrique dirigé selon la direction de croissance du super-réseau,
- la figure 3 illustre le fonctionnement du modulateur selon le mode dit à décalage vers le bleu,
- la figure 4 illustre le fonctionnement du modulateur selon le mode dit à transition oblique,
- la figure 5 montre la variation du photocourant en fonction de la longueur d'onde pour deux tensions appliquées au modulateur,
- la figure 6 montre les variations du seuil d'effet laser et de la longueur d'onde du laser en fonction de la longueur de la cavité,
- la figure 7 montre schématiquement la structure d'un composant conforme à l'invention.

**Exposé détaillé d'un mode de réalisation**

Avant de décrire la structure d'un composant conforme à l'invention, le principe et les propriétés d'un super-réseau très couplé vont être rappelés.

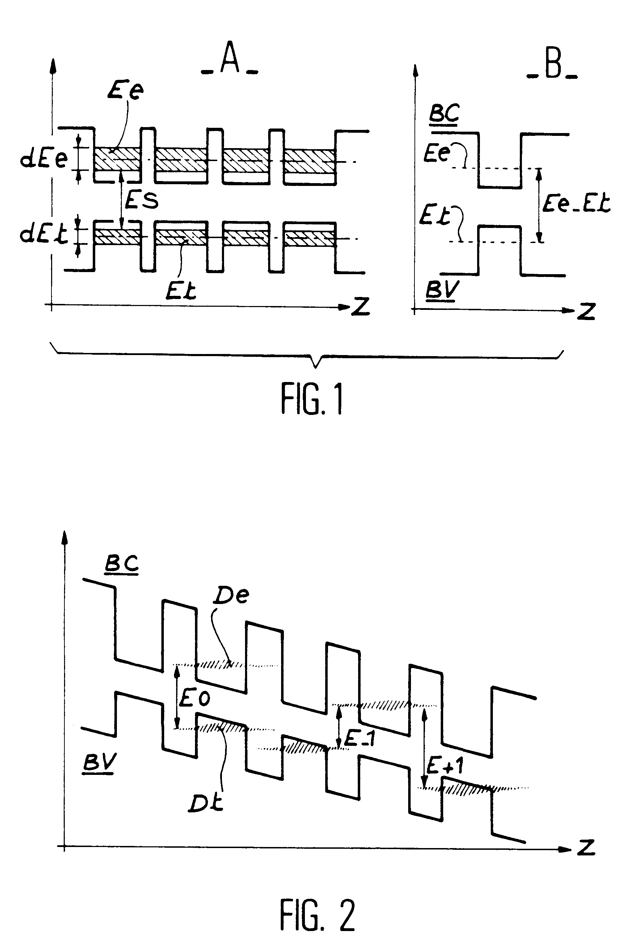

Sur les figures 1 et 2, BC désigne la bande de conduction, BV la bande de valence, l'abscisse Z représente la distance comptée perpendiculairement au plan des couches et l'ordonnée correspond à l'énergie.

Conformément à la figure 1, partie A, un super-réseau très couplé est une succession de puits et de barrières de potentiel, dans laquelle les épaisseurs respectives des puits et des barrières sont très faibles, de sorte que les puits sont très couplés les uns aux autres, par effet tunnel résonnant.

Ce fort couplage entraîne la création de minibandes d'énergie de largeurs dEe et dEt, respectivement autour des niveaux d'énergie quantifiés des électrons et des trous que l'on trouverait dans un puits quantique unique (partie B).

On rappelle, à ce propos, qu'un super-réseau très couplé est tel que :

$$dEe + dEt \geqq 10 \text{ meV}.$$

Par application au super-réseau d'un faible champ électrique selon la direction de croissance de ce super-réseau, on brise le couplage entre puits par suppression de l'effet tunnel résonnant.

La probabilité de l'effet tunnel diminuant, les fonctions d'onde De et Dt régissant la probabilité de présence des électrons et des trous tendent à se localiser essentiellement dans les puits, selon un mécanisme dit de "localisation de WANNIER-STARK".

En termes d'absorption, cela signifie que le front d'absorption qui se situait à une énergie Es, passe à une valeur supérieure Eo sensiblement égale à Es augmenté de la demi-somme de (dEe + dEt). Il y a ainsi décalage du front vers les hautes énergies ou, si l'on compte en longueur d'onde, décalage vers le bleu.

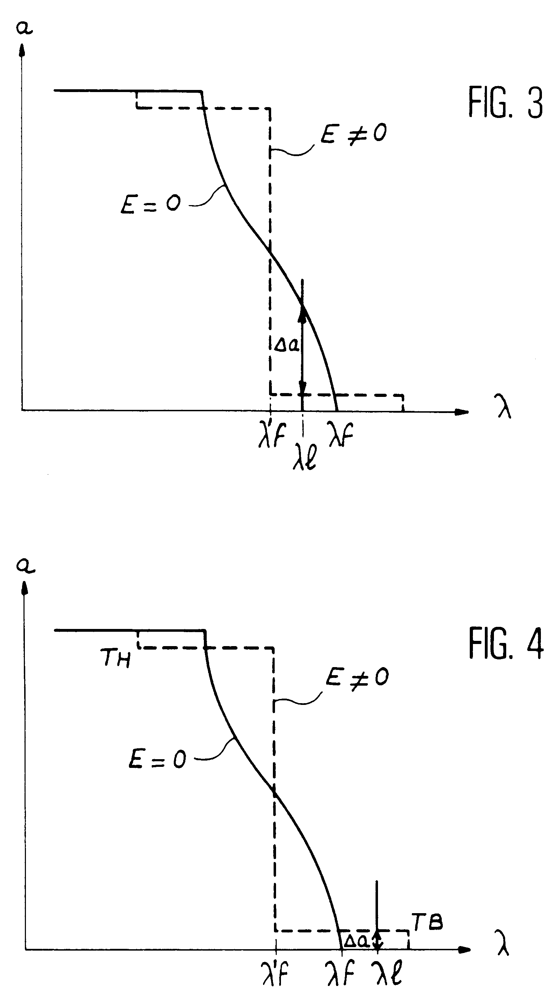

La figure 3 montre ainsi les variations théoriques d'absorption (a) en fonction de la longueur d'onde $\lambda$ sans champ électriqe (E=o) (courbe en trait continu) et avec champ électrique (E$\neq$0, courbe en tirets). Ce front d'absorption se décale de la valeur $\lambda f$ à la valeur $\lambda'f$.

L'effet de décalage vers le bleu du seuil d'absorption dans les super-réseaux très couplés a été décrit dans l'article de J. BLEUSE, G. BASTARD et P. VOISIN, publié dans Phys. Rev. Lett., vol. 60, n° 3, 18 janvier 1988, pp. 220 à 223, ainsi que dans l'article de J. BLEUSE, P. VOISIN, M. ALLOVON et M. QUILLEC, publié dans Applied Physics Letters 53(26), 26 décembre 1988, pp. 2632 à 2634, ainsi que dans la demande de brevet français FR-A-2 607 628 déjà citée.

La transition d'énergie Eo représentée sur la figure 2 correspond à un même puits quantique. Mais d'autres transitions sont possibles entre puits voisins. Ces transitions sont dites "obliques" (parce qu'elles impliquent justement des puits adjacents). Ces transitions obliques apparaissent soit à plus basse énergie (type E-1), soit à plus haute énergie (type E+1) par rapport à la transition fondamentale à Eo.

La figure 4 montre ainsi les variations théoriques d'absorption (a) en fonction de la longueur d'onde $\lambda$, en l'absence de champ électrique (E=0), (courbe en trait continu) et en présence de champ électrique (E$\neq$0), (courbe en tirets). La bande en forme d'escalier TB correspond à une transition oblique à basse énergie et la bande TH à une transition oblique à haute énergie.

C'est la bande TB à basse énergie qui est utilisée dans la seconde variante de l'invention.

Les variations d'absorption ($\Delta a$) obtenues par apparition d'une transition oblique à basse énergie (Fig. 4) sont relativement faibles (quelques centaines de cm$^{-1}$). Elles sont nettement moins importantes que dans le cas du décalage vers le bleu (Fig. 3). Néanmoins, ces variations d'absorption présentent plusieurs avantages :

- elles apparaissent dans une région où l'absorption à l'état passant est très faible. En utilisant une longueur d'onde adéquate, on peut donc obtenir un bon taux d'extinction tout en conservant une atténuation à l'état passant faible ;
- elles apparaissent pour des champs électriques faibles et donc pour des tensions de commande faibles (typiquement 1V appliqué à une épaisseur de 0,5 micromètre) ;
- elles permettent un fonctionnement sur une plage spectrale relativement large et conduisent donc à une grande tolérance de fabrication sur les modulateurs ainsi qu'une optimisation aisée de ceux-ci.

Des modulateurs à super-réseau très couplé travaillant sur la transition oblique à basse énergie sont décrits dans la demande de brevet français FR-A-2 655 433 déjà citée.

Quant au laser, qui est constitué lui aussi par le même super-réseau très couplé, sa longueur d'onde $\lambda l$ va se situer juste au-dessus de l'énergie de la bande interdite, à une valeur qui dépend du remplissage effectif des bandes, donc de la densité de porteurs injectés. Cela donne donc une certaine plage possible pour la longueur d'onde du laser, plage qui se situe au-dessus de la bande interdite effective du super-réseau en fonctionnement. Comme un laser fonctionne en polarisation directe (injection de porteurs), la bande interdite à prendre en compte est celle du super-réseau en l'absence de champ électrique, diminuée éventuellement par l'effet de "renormalisation du gap" évoqué plus haut et dû à la densité de porteurs injectés.

Lorsque le modulateur travaille en mode à décalage vers le bleu, il n'y a donc aucun problème de compatibilité en longueur d'onde entre le laser et ce modulateur, puisque, contrairement à l'effet STARK décrit dans l'art antérieur, l'application d'un champ électrique au super-réseau couplé produit un décalage vers le bleu du front d'absorption, ce qui a pour conséquence de rendre le super-réseau transparent à une longueur d'onde où il était initialement opaque. Ces variations négatives d'absorption, par application d'un champ électrique, qui sont caractéristiques du fonctionnement en décalage vers le bleu, se produisent pour des énergies situées juste au-dessus de la bande interdite du super-réseau à champ nul, donc précisément dans la plage de longueur d'onde du laser formé de ce même super-réseau. L'intégration de ce type de modulateur avec le laser est donc particulièrement simple.

On voit ainsi, sur la figure 3, la longueur d'onde $\lambda l$ de fonctionnement de l'ensemble, qui est située en dessous de la longueur d'onde $\lambda f$ du front d'absorption en l'absence de champ électrique et au-dessus de la lon-

EP 0 531 214 B1

gueur d'onde λ'f de ce front en présence de champ électrique.

Cependant, les performances de ce type de modulateur ne sont pas optimales, surtout parce que la transparence dans l'état passant n'est pas très bonne. D'où l'intérêt d'intégrer un modulateur à transition oblique, qui présente, lui, des performances nettement supérieures pour l'application envisagée (tensions de commande très faibles, bon contraste de modulation). Mais, dans ce cas, on retrouve un problème de compatibilité en longueur d'onde comme dans l'art antérieur avec cependant un avantage considérable lié au fait que l'écart de longueur d'onde est maintenant beaucoup plus faible qu'avec les structures de l'art antérieur.

La figure 4 montre alors la longueur d'onde du laser λl qui se situe dans la plage d'absorption liée à la transition oblique à basse énergie (TB), c'est-à-dire au-dessus de la longueur d'onde λf du front d'absorption en l'absence de champ électrique.

Tous les moyens décrits dans l'art antérieur peuvent être utilisés soit pour décaler le fonctionnement du modulateur vers le bleu, soit pour décaler la longueur d'onde du laser vers les grandes longueurs d'ondes. On peut utiliser par exemple les variations locales de vitesse d'épitaxie ou l'interdiffusion des constituants. On peut, en particulier, décaler la longueur d'onde du laser par dopage de la couche active. En contraste avec ce qui a déjà été publié dans ce domaine (niveaux de dopage élevés obtenus a posteriori par implantation ou diffusion localisée), on peut doper la couche active du laser pendant l'épitaxie, simultanément n et p, avec des niveaux de dopage modérés. Cela peut suffire à élargir le pic de gain du laser. Comme dans un laser DFB la longueur d'onde est fixée en pratique par le pas du réseau de BRAGG, il est possible de décaler légèrement cette longueur d'onde par rapport au maximum du pic de gain (cela se fait couramment dans les lasers DFB à modulation directe, mais dans l'autre sens), sans dégrader significativement le courant de seuil.

On va décrire maintenant un exemple de réalisation d'un composant monolithique intégré conforme à l'invention.

Pour fonctionner à une longueur d'onde proche de 1,5 μm, on peut utiliser les matériaux GaInAs et AlInAs épitaxiés à l'accord de maille sur InP, par épitaxie par jet moléculaire (EJM).

La structure des diverses couches est détaillée sur le tableau suivant. La première colonne donne l'épaisseur des couches, la seconde leur composition et la troisième le type de dopage.

| 0,1 μm | : | GaInAs | : | p $2.10^{19}$ |
|---|---|---|---|---|
| 1,8 μm | : | AlInAs | : | p $5.10^{17}$ |
| 0,0825 μm | : | 15 x (2,5 nm GaInAs/3 nm AlInAs) | : | non dopé |
| 0,15 μm | : | 20 x (6 nm GaInAs/1,5 nm AlInAs) | : | non dopé |
| 0,0825 μm | : | 15 x (2,5 nm GaInAs/3 nm AlInAs) | : | non dopé |
| 0,1 μm | : | AlInAs | : | n $5.10^{17}$ |
| 80 μm | : | InP (substrat) | : | n+ |

Le super-réseau central est le super-réseau électro-absorbant. Les super-réseaux adjacents n'ont qu'un rôle de confinement optique et n'influent pas sur les propriétés d'électro-absorption ou d'émission.

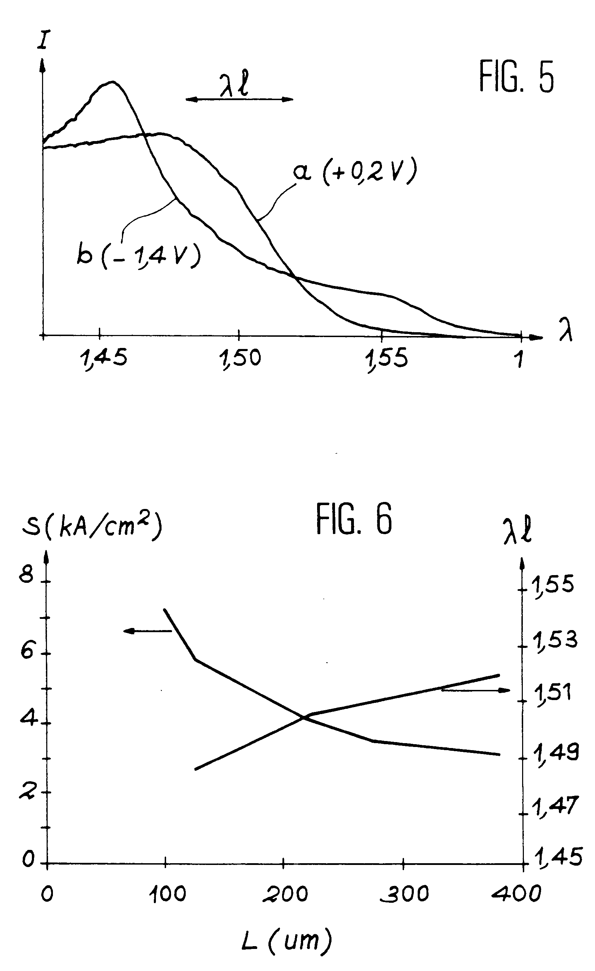

Le spectre de photocourant I(λ) mesuré en ondes guidées sur cette structure (avec un guide très court d'environ 5 μm) est représenté sur la figure 5. Il représente l'absorption dans le super-réseau. Les deux courbes correspondent à des tensions appliquées de 0,2 V (courbe a) et -1,4 V (courbe b).

La gamme de longueur d'onde d'utilisation d'une telle structure en modulateur du type à "décalage vers le bleu" s'étend théoriquement entre les deux points de croisement des deux courbes. En pratique, elle se situe au voisinage de 1,5 μm pour cette structure.

A cette longueur d'onde, un modulateur de 30 μm de long présente un taux d'extinction d'environ 7 dB

7

pour une variation de tension appliquée de 1,6 V, avec une atténuation résiduelle en état passant d'environ 10 dB. Ces performances assez modestes s'expliquent en partie par le fait que cette structure n'a pas été optimisée pour fonctionner à cette longueur d'onde en mode à décalage vers le bleu, mais plutôt pour la longueur d'onde de 1,55 µm utilisant le mode de transition oblique.

Lorsque cette même structure est polarisée en direct, elle donne lieu à une émission stimulée avec des courants de seuil raisonnables, bien qu'elle n'ait pas été optimisée pour l'utilisation en laser (choix des matériaux, épaisseur de couche active, ...). Les résultats sont représentés sur la figure 6 en fonction de la longueur de la cavité. En augmentant cette longueur, la densité de porteurs nécessaire pour obtenir l'émission stimulée diminue, donc la densité de courant de seuil aussi, tandis que la longueur d'onde de laser $\lambda l$ augmente, ce qui offre une certaine plage de longueur d'onde pour le fonctionnement en laser. Cette plage a été reportée sur la figure 5 par un intervalle fléché. Cette plage laser recouvre la plage de décalage vers le bleu, ce qui justifie l'intérêt de ce type de structure pour l'intégration d'un laser avec un modulateur à décalage vers le bleu.

Pour l'intégration avec un modulateur à transition oblique, on constate que la longueur d'onde laser maximale (1,52 µm), obtenue pour une longueur de cavité de 380 µm seulement se situe au seuil de la gamme de fonctionnement du modulateur en transition oblique (qui commence au point de croisement des deux courbes), à seulement 30 nm (environ 15 meV) du point de fonctionnement optimum de cette structure en tant que modulateur. En effet, on obtient à 1,55 µm un taux d'extinction de 13 dB/100 µm pour une variation de tension de 1,6 V et une absorption résiduelle de 3 dB/100 µm seulement.

Les performances élevées de ce type de modulateur et le faible écart en longueur d'onde constaté par rapport à la plage laser sur une structure non optimisée justifient l'intérêt de l'intégration d'un laser avec un modulateur de ce type à l'aide des moyens simples proposés plus haut.

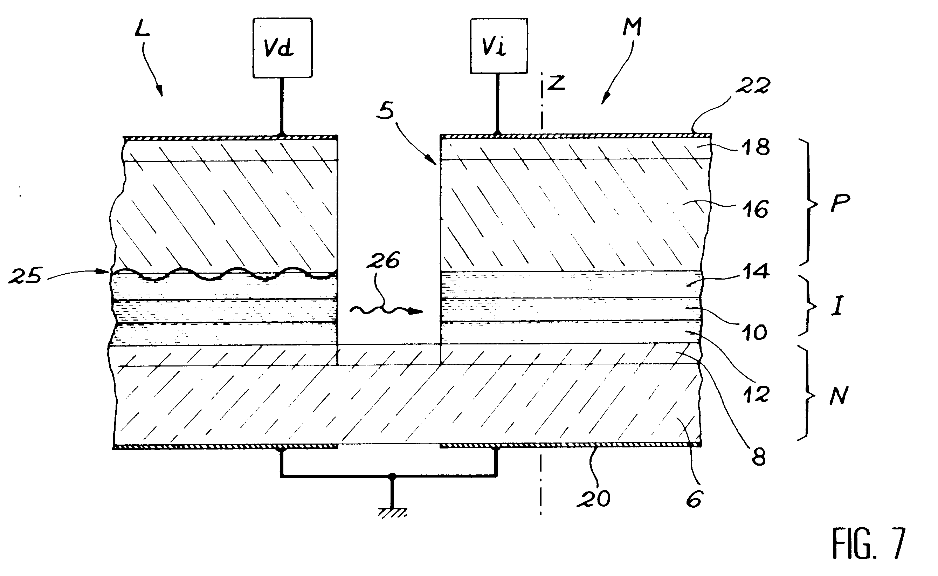

Ces considérations sur la structure et le fonctionnement du composant de l'invention ayant été faites, on peut en décrire un mode particulier de réalisation et cela en liaison avec la figure 7. Le composé représenté comprend un laser L et un modulateur M identiques, si ce n'est que le laser est polarisé en direct par une source de tension Vd alors que le modulateur est polarisé en inverse par une source de tension Vi. Comme les deux structures sont identiques seule l'une d'entre elles sera décrite, à savoir celle du modulateur. Telle que représentée, cette structure est du type PIN, avec une région intrinsèque I qui, selon l'invention, comprend un super-réseau très couplé 10. La région N comprend un substrat 6 en InP-n+ dont l'épaisseur est par exemple de 80 µm et, sur ce substrat, une couche-tampon 8 en AlInAs-n de 0,1 µm d'épaisseur.

Le super-réseau a l'indice optique le plus élevé et comprend 20 couches de GaInAs non intentionnellement dopé de 6 nm d'épaisseur chacune, qui alternent avec 20 couches de AlInAs non intentionnellement dopé de 1,5 nm d'épaisseur chacune.

La région I comprend aussi deux multicouches 12 et 14 identiques entre lesquelles est placé le super-réseau 10 et dont l'indice optique est inférieur à celui du super-réseau mais supérieur à ceux des régions N et P, ces derniers indices étant identiques.

Chacune des multicouches 12 et 14 comprend 15 couches de GaInAs non intentionnellement dopé de 2,5 nm d'épaisseur chacune, qui alternent avec 15 couches de AlInAs non intentionnellement dopé de 3 nm d'épaisseur chacune. Ces super-réseaux n'ont qu'un rôle de confinement optique et ne constituent pas une caractéristique de l'invention.

La région P de la diode comprend une couche de confinement 16 en AlInAs-p de 2 µm d'épaisseur. La région P comprend en outre, sur la couche 16, une couche de contact 18 en GaInAs-p+ de 0,1 µm d'épaisseur.

On a indiqué sur la figure 7 la direction Z de croissance du super-réseau. Cette direction Z est perpendiculaire au plan des couches du super-réseau.

Des couches métalliques 20 et 22, par exemple en or, sont respectivement déposées sur la face libre du substrat 6 et sur la face libre de la couche 18.

Le faisceau lumineux 26 est produit par le laser L et est injecté dans le modulateur M en polarisation TE (transverse électrique).

Dans le laser, un réseau de BRAGG porte la référence 25.

L'alignement automatique des deux super-réseaux conduit ipso facto à l'alignement optique de la couche active du laser et de la couche absorbante du modulateur. Le couplage optique entre laser et modulateur est donc excellent, par construction même du composant.

## Revendications

1. Composant électrooptique monolithique intégré comprenant, sur un même substrat :
   - un modulateur électrooptique (M) formé d'un empilement de couches semiconductrices, dont une couche absorbante (10),

- un laser à semiconducteur (L) formé d'un empilement de couches semiconductrices dont une couche active (10),
- des moyens (Vd, 20, 22) pour appliquer à l'empilement de couches du laser une tension électrique directe créant un champ électrique perpendiculaire au plan des couches, ce laser émettant alors, par sa couche active (10), un rayonnement (26) traversant la couche absorbante (10) du modulateur (M) dans le plan de cette couche absorbante (10),
- des moyens (Vi, 20, 22) pour appliquer à l'empilement de couches du modulateur (M) une tension électrique inverse créant un champ électrique perpendiculaire au plan des couches pour moduler l'absorption du rayonnement traversant le modulateur,

ce composant étant caractérisé par le fait que la couche active (10) du laser (L) et la couche absorbante (10) du modulateur (M) sont toutes deux constituées par une même structure épitaxiée du type super-réseau très couplé, ce super-réseau très couplé étant un réseau de composition, avec alternance de couches semiconductrices de compositions différentes, et par le fait que le super-réseau très couplé du modulateur (M) présente une bande d'absorption présentant un front situé à une certaine longueur d'onde ($\lambda f$) en l'absence de champ électrique appliqué au super-réseau du modulateur, ce front se décalant vers une plus courte longueur d'onde ($\lambda'f$) en présence d'un fort champ électrique appliqué, selon un mode de fonctionnement dit à déplacement vers le bleu, le rayonnement émis par le super-réseau du laser ayant une longueur d'onde ($\lambda l$) légèrement inférieure à la longueur d'onde ($\lambda f$) du front d'absorption en l'absence de champ électrique mais légèrement supérieure à la longueur d'onde ($\lambda'f$) du front en présence de champ électrique, le modulateur étant ainsi opaque au rayonnement laser en l'absence de tension appliquée au modulateur et sensiblement transparent à ce rayonnement en présence de tension appliquée à ce modulateur.

2. Composant électrooptique monolithique intégré, comprenant, sur un même substrat :
   - un modulateur électrooptique (M) formé d'un empilement de couches semiconductrices, dont une couche absorbante (10),
   - un laser à semiconducteur (L) formé d'un empilement de couches semiconductrices dont une couche active (10),
   - des moyens (Vd, 20, 22) pour appliquer à l'empilement de couches du laser une tension électrique directe créant un champ électrique perpendiculaire au plan des couches, ce laser émettant alors, par sa couche active (10), un rayonnement (26) traversant la couche absorbante (10) du modulateur (M) dans le plan de cette couche absorbante (10),
   - des moyens (Vi, 20, 22) pour appliquer à l'empilement de couches du modulateur (M) une tension électrique inverse créant un champ électrique perpendiculaire au plan des couches pour moduler l'absorption du rayonnement traversant le modulateur,

ce composant étant caractérisé par le fait que la couche active (10) du laser (L) et la couche absorbante (10) du modulateur (M) sont toutes deux constituées par une même structure épitaxiée du type super-réseau très couplé, ce super-réseau très couplé étant un réseau de composition avec alternance de couches semiconductrices de compositions différentes et caractérisé par le fait que le super-réseau très couplé du modulateur présente une bande d'absorption présentant un front situé à une certaine longueur d'onde ($\lambda f$) en l'absence de champ électrique appliqué, une bande d'absorption (TB) située à des longueurs d'ondes plus grandes apparaissant lorsqu'un faible champ électrique est appliqué au super-réseau du modulateur, selon un mode de fonctionnement dit "à transition oblique", le rayonnement émis par le super-réseau du laser (L) ayant une longueur d'onde ($\lambda l$) légèrement supérieure à la longueur d'onde ($\lambda f$) du front d'absorption en l'absence de champ électrique et tombant dans la bande d'absorption (TB) apparaissant en présence d'un champ électrique, le modulateur étant ainsi transparent au rayonnement laser en l'absence de tension appliqué au modulateur et opaque à ce rayonnement en présence de tension appliquée à ce modulateur.

3. Composant selon la revendication 2, caractérisé par le fait que les super-réseaux très couplés constituant la couche active (10) du laser (L) et la couche absorbante (10) du modulateur (M) ont été dopés pendant l'épitaxie simultanément n et p avec un niveau de dopage modéré, ce dopage n, p ayant pour effet d'élargir la courbe de gain du laser.

4. Composant selon l'une quelconque des revendications 1 à 3, caractérisé par le fait que le laser est du type à réaction distribuée (DFB) avec un réseau de BRAGG (25).

5. Composant selon la revendication 4, caractérisé par le fait que le réseau de BRAGG (25) présente un pas fixant la longueur d'onde ($\lambda$l) de fonctionnement du laser à une valeur un peu au-delà de la longueur d'onde correspondant au maximum du pic de gain du laser.

6. Composant selon l'une quelconque des revendications 1 à 5, caractérisé par le fait que les super-réseaux constituant la couche active (10) du laser (L) et la couche absorbante (10) du modulateur (M) sont constitués par un empilement de couches épitaxiées alternativement en alliages ternaires ou quaternaires GaIn(Al)As et (Ga)AlInAs.

7. Composant selon l'une quelconque des revendications 1 à 5, caractérisé par le fait que les super-réseaux constituant la couche active (10) du laser (L) et la couche absorbante (10) du modulateur (M) sont constitués par un empilement de couches épitaxiées alternativement en alliages ternaires ou quaternaires GaInAs(P) et In(GaAs)P.

8. Composant selon l'une quelconque des revendications 1 à 5, caractérisé par le fait que les super-réseaux constituant la couche active (10) du laser (L) et la couche absorbante (10) du modulateur (M) sont constitués par un empilement de couches épitaxiées alternativement en matériaux de puits et de barrières adéquats pour un domaine de longueur d'onde déterminé.

**Patentansprüche**

1. Monolithisch integriertes elektrooptisches Bauteil, das auf ein und demselben Trägermaterial folgende Teile enthält:
   - einen elektrooptischen Modulator (M), der aus übereinanderliegenden Halbleiterschichten gebildet wird, von denen eine Schicht eine Absorptionsschicht ist (10),
   - einen Halbleiter-Laser (L) bestehend aus übereinanderliegenden Halbleiterschichten, von denen eine Schicht eine aktive Schicht ist (10),
   - Vorrichtungen (Vd, 20, 22) zum Anlegen einer direkten elektrischen Spannung an die übereinanderliegenden Schichten des Lasers, wodurch ein elektrisches, senkrecht zur Ebene der Schichten verlaufendes Feld erzeugt wird und somit der Laser durch seine aktive Schicht (10) eine Strahlung (26) aussendet, die die Absorptionsschicht (10) des Modulators (M) in der Ebene dieser absorbierenden Schicht (10) durchquert,
   - Vorrichtungen (Vi, 20, 22) zum Anlegen einer umgekehrten elektrischen Spannung an die übereinanderliegenden Schichten des Modulators (M), wodurch ein elektrisches, senkrecht zur Ebene der Schichten Verlaufendes Feld erzeugt wird, mit Hilfe dessen die Absorption der den Modulator durchquerenden Strahlung moduliert wird,
   wobei dieses Bauteil dadurch gekennzeichnet ist, daß die aktive Schicht (10) des Lasers (L) und die absorbierende Schicht (10) des Modulators (M) beide aus ein und demselben epitaktischen Gefüge vom Typ eines stark gekoppelten Übergitters gebildet werden, wobei dieses stark gekoppelte Übergitter ein zusammengesetztes Gitter ist, bei dem sich Halbleiterschichten mit unterschiedlicher Zusammensetzung abwechseln, sowie dadurch gekennzeichnet ist, daß das stark gekoppelte Übergitter des Modulators (M) ein Absorptionsband aufweist, welches bei Abwesenheit des elektrischen, an das Übergitter des Modulators angelegten Feldes eine bei einer bestimmten Wellenlänge (Lambda f) befindliche Front aufweist, die sich bei Vorhandensein eines angelegten, starken elektrischen Feldes in Richtung einer kürzeren Wellenlänge (Lambda'f) nach einer als Blauverschiebung bezeichneten Funktionsweise verschiebt, wobei die vom Übergitter des Lasers ausgesendete Strahlung eine Wellenlänge (Lambda l) hat, die ein wenig unter der Wellenlänge (Lambda f) der Absorptionsfront bei Abwesenheit des elektrischen Feldes, jedoch ein wenig über der Wellenlänge (Lambda' f) der Front bei vorhandensein des elektrischen Feldes liegt, wodurch der Modulator bei Abwesenheit der an den Modulator angelegten Spannung für die Laserstrahlung undurchlässig und bei Vorhandensein der an diesen Modulator angelegten Spannung für diese Strahlung äußerst durchlässig ist.

2. Monolithisch integriertes elektrooptisches Bauteil, das auf ein und demselben Trägermaterial folgende Teile enthält:
   - einen elektrooptischen Modulator (M), der aus übereinanderliegenden Halbleiterschichten gebildet wird, von denen eine Schicht eine Absorptionsschicht ist (10),
   - einen Halbleiter-Laser (L) bestehend aus übereinanderliegenden Halbleiterschichten, von denen eine Schicht eine aktive Schicht ist (10),

- Vorrichtungen (Vd, 20, 22) zum Anlegen einer direkten elektrischen Spannung an die übereinanderliegenden Schichten des Lasers, wodurch ein elektrisches, senkrecht zur Ebene der Schichten verlaufendes Feld erzeugt wird und somit der Laser durch seine aktive Schicht (10) eine Strahlung (26) aussendet, die die Absorptionsschicht (10) des Modulators (M) in der Ebene dieser absorbierenden Schicht (10) durchquert,

- Vorrichtungen (Vi, 20, 22) zum Anlegen einer umgekehrten elektrischen Spannung an die übereinanderliegenden Schichten des Modulators (M), wodurch ein elektrisches, senkrecht zur Ebene der Schichten verlaufendes Feld erzeugt wird, mit Hilfe dessen die Absorption der den Modulator durchquerenden Strahlung moduliert wird, wobei dieses Bauteil dadurch gekennzeichnet ist, daß die aktive Schicht (10) des Lasers (L) und die absorbierende Schicht (10) des Modulators (M) beide aus ein und demselben epitaktischen Gefüge vom Typ eines stark gekoppelten Übergitters gebildet werden, wobei dieses stark gekoppelte Übergitter ein zusammengesetztes Gitter ist, bei dem sich Halbleiterschichten mit unterschiedlicher Zusammensetzung abwechseln, sowie dadurch gekennzeichnet ist, daß das stark gekoppelte Übergitter des Modulators ein Absorptionsband aufweist, welches bei Abwesenheit des elektrischen, angelegten Feldes eine bei einer bestimmten Wellenlänge (Lambda f) befindliche Front aufweist, und zwar ein Absorptionsband (TB), welches sich in größeren Wellenlängen befindet und nach einer als "Schrägübergang" bezeichneten Funktionsweise auftritt, sobald ein schwaches elektrisches Feld an das Übergitter des Modulators angelegt wird, wobei die von dem Übergitter des Lasers (L) ausgesendete Strahlung eine Wellenlänge (Lambda l) besitzt, die bei Abwesenheit des elektrischen Feldes etwas über der Wellenlänge (Lambda f) der Absorptionsfront liegt und in das Absorptionsband (TB) fällt, welches bei Vorhandensein eines elektrischen Feldes auftritt, wodurch somit der Modulator bei Abwesenheit der an den Modulator angelegten Spannung für die Strahlung durchlässig und bei Vorhandensein der an diesen Modulator angelegten Spannung für diese Strahlung undurchlässig ist.

3. Bauteil nach Anspruch 2, dadurch gekennzeichnet, das die stark gekoppelten Übergitter, welche die aktive Schicht des Lasers (L) und die absorbierende Schicht (10) des Modulators (M) bilden, während der Epitaxie gleichzeitig mit n und p bei einem mäßigen Dotierungsgrad dotiert wurden, wobei diese Dotierung n,p zu einer Erweiterung der Verstärkungskurve des Lasers führt.

4. Bauteil nach einem der Ansprüche 1 bis 3, dadurch gekennzeichnet, daß der Laser ein Laser mit verteilter Rückkopplung (DFB) mit einem BRAGG-Gitter (25) ist.

5. Bauteil nach Anspruch 4, dadurch gekennzeichnet, daß das BRAGG-Gitter (25) eine Teilung aufweist, durch die die Betriebswellenlänge (Lambda l) des Lasers auf einen Wert festgelegt wird, der etwas über der Wellenlänge liegt, die dem Maximum des verstärkungspiks des Lasers entspricht.

6. Bauteil nach einem der Ansprüche 1 bis 5, dadurch gekennzeichnet, daß die Übergitter, die die aktive Schicht (10) des Lasers (L) und die absorbierende Schicht (10) des Modulators (M) bilden, aus übereinanderliegenden epitaktischen Schichten gebildet werden, die jeweils abwechselnd aus; Dreistoff- oder Vierstofflegierungen GaIn(Al)As und (Ga)AlInAs bestehen.

7. Bauteil nach einem der Ansprüche 1 bis 5, dadurch gekennzeichnet, daß die Übergitter, die die aktive Schicht (10) des Lasers (L) und die absorbierende Schicht (10) des Modulators (M) bilden, aus übereinanderliegenden epitaktischen Schichten gebildet werden, die jeweils abwechselnd aus Dreistoff- oder Vierstofflegierungen GaInAs(P) und In(GaAs) P bestehen.

8. Bauteil nach einem der Ansprüche 1 bis 5, dadurch gekennzeichnet, daß die Übergitter, die die aktive Schicht (10) des Lasers (L) und die absorbierende Schicht (10) des Modulators (M) bilden, aus übereinanderliegenden epitaktischen Schichten gebildet werden, die jeweils abwechselnd aus durchlässigen und undurchlässigen Materialien bestehen, die für einen vorgegebenen Wellenlängenbereich angemessen sind.

## Claims

1. Integrated monolithic electrooptical component comprising on the same substrate an electrooptical modulator (M) formed from a stack of semiconductor layers, including an absorbent layer (10), a semiconductor laser (L) formed from a stack of semiconductor layers, including an active layer (10), means (Vd, 20, 22) for applying to the stack of laser layers a forward voltage creating an electric field perpendicular to the plane of the layers, the laser then emitting by its active layer (10) a radiation (26) traversing the absorbent layer (10) of the modulator (M) in the plane of said layer (10), means (Vi, 20, 22) for applying to the stack of layers of the modulator (M) a reverse voltage creating an electric field perpendicular to the plane of the layers to modulate the absorption of the radiation traversing the modulator, characterized in that the active layer (10) of the laser (L) and the absorbent layer (10) of the modulator (M) are both constituted by the same epitaxied structure of the highly coupled superlattice type, which is a composition lattice having an alternation of the semiconductor layers of different compositions and by the fact that the highly coupled superlattice of the modulator (M) has an absorption band with a front located at a certain wavelength ($\lambda$f) in the absence of an electric field applied to the superlattice of the modulator, said front being displaced towards a shorter wavelength ($\lambda'$f) in the presence of a strong electric field applied, in accordance with an operating mode called a blue shift mode, the radiation emitted by the superlattice of the laser having a wavelength ($\lambda$l) slightly below the wavelength ($\lambda$f) of the absorption front in the absence of an electric field, but slightly above the wavelength ($\lambda'$f) of the front in the presence of an electric field, so that the modulator is opaque to the laser radiation in the absence of voltage applied to the modulator and substantially transparent to said radiation in the presence of voltage applied to said modulator.

2. Integrated monolithic electrooptical component comprising on the same substrate an electrooptical modulator (M) formed from a stack of semiconductor layers, including an absorbent layer (10), a semiconductor laser (L) formed from a stack of semiconductor layers, including an active layer (10), means (Vd, 20, 22) for applying to the stack of laser layers a forward voltage creating an electric field perpendicular to the plane of the layers, the laser then emitting by its active layer (10) a radiation (26) traversing the absorbent layer (10) of the modulator (M) in the plane of said layer (10), means (Vd, 20, 22) for applying to the stack of layers of the modulator (M) a reverse voltage creating an electric field perpendicular to the plane of the layers to modulate the absorption of the radiation traversing the modulator, characterized in that the active layer (10) of the laser (L) and the absorbent layer (10) of the modulator (M) are both constituted by the same epitaxied structure of the highly coupled superlattice type, which is a composition lattice having an alternation of semiconductor layers of different compositions and characterized in that the highly coupled superlattice of the modulator has an absorption band with a front located at a certain wavelength ($\lambda$f) in the absence of an electric field applied, an absorption band (TB) located at higher wavelengths appearing when a weak electric field is applied to the superlattice of the modulator, in accordance with an operating mode called the "oblique transition mode", the radiation emitted by the superlattice of the laser (L) having a wavelength ($\lambda$l) slightly above the wavelength ($\lambda$f) of the absorption front in the absence of an electric field and dropping into the absorption band (TB) appearing in the presence of an electric field, so that the modulator is transparent to the laser radiation in the absence of voltage applied to the modulator and opaque to said radiation in the presence of voltage applied to said modulator.

3. Component according to claim 2, characterized in that the highly coupled superlattices constituting the active layer (10) of the laser (L) and the absorbent layer (10) of the modulator (M) have been doped simultaneously n and p during epitaxy with a moderate doping level, said n and p doping having the effect of widening the laser gain curve.

4. Component according to any one of the claims 1 to 3, characterized in that the laser is of the distributed feedback (DFB) type with a BRAGG grating (25).

5. Component according to claim 4, characterized in that the BRAGG grating (25) has a spacing which fixes the operating wavelength ( l) of the laser to a value just beyond the wavelength corresponding to the maximum of the laser gain peak.

6. Component according to any one of the claims 1 to 5, characterized in that the superlattices constituting the active layer (10) of the laser (L) and the absorbent layer (10) of the modulator (M) are constituted by a stack of alternately epitaxied layers of ternary or quaternary alloys GaIn(Al)As and (Ga)AlInAs.

7. Component according to any one of the claims 1 to 5, characterized in that the superlattices constituting the active layer (10) of the laser (L) and the absorbent layer (10) of the modulator (M) are constituted by a stack of alternately epitaxied layers of ternary or quaternary alloys GaInAs(P) and In(GaAs)P.

8. Component according to any one of the claims 1 to 5, characterized in that the superlattices constituting the active layer (10) of the laser (L) and the absorbent layer (10) of the modulator (M) are constituted by a stack of alternately epitaxied layers of adequate well and barrier materials for a given wavelength range.

FIG. 1

FIG. 2

FIG. 3

FIG. 4

FIG. 5

FIG. 6

FIG. 7